# EUROPEAN PATENT SPECIFICATION

(11) **EP 1 289 351 B1**
(45) Date of publication and mention of the grant of the patent: **16.05.2007**
(21) Application number: 01830550.8
(22) Date of filing: 29.08.2001
(51) Int. Cl.: H05K 1/14

(54) **Improved electronic board**
Verbesserte elektronische Platte
Panneau électronique amélioré

(43) Date of publication of application: 05.03.2003
(73) Proprietor: Gefran S.p.A., 25050 Provaglio d'Iseo (Brescia) (IT)
(72) Inventor: Tonello, Giovanni, c/o Gefran S.p.a., 25050 Provaglio D'Iseo (Brescia) (IT)
(74) Representative: Leihkauf, Steffen Falk

(56) References cited:
- EP-A- 1 033 909
- CA-A- 2 209 981
- FR-A- 2 643 211
- GB-A- 1 015 264
- GB-A- 2 243 247
- US-A- 3 961 228
- US-A- 5 648 891
- PATENT ABSTRACTS OF JAPAN vol. 014, no. 444 (E-0982), 21 September 1990 (1990-09-21) & JP 02 177386 A (NEC CORP), 10 July 1990 (1990-07-10)
- PATENT ABSTRACTS OF JAPAN vol. 017, no. 356 (E-1394), 6 July 1993 (1993-07-06) & JP 05 055766 A (FUJITSU LTD), 5 March 1993 (1993-03-05)
- PATENT ABSTRACTS OF JAPAN vol. 1996, no. 06, 28 June 1996 (1996-06-28) & JP 08 032196 A (SHARP CORP), 2 February 1996 (1996-02-02)

## Description

### Application field

The present invention relates to an electronic board and, more particularly, to a wired electronic board for application in precision measuring devices and instruments.

More particularly, but not exclusively, the invention relates to an electronic board for supporting discrete or integrated electronic components electrically connected by means of conductive tracks realised on or in the board.

### Prior art

As it is well known in this specific application field, most of electronic devices and/or electronic instruments for civil, industrial or military use are structured with an outer shell enclosing and protecting one or more inner electronic boards, which are the operating core of the device.

These boards are of the conventional type and can be made out of different materials which share the common feature of being electrical insulators or, anyway, bad electric current conductors. This allows conductive tracks which are interconnected or reciprocally insulated according to a predetermined topography to be realised in or on the boards. The board insulating structure is essentially exploited to keep some conductive tracks electrically insulated between each other, while other tracks define electrically unipotential circuit meshes.

The conductive tracks allow several electronic components, either of the discrete or of the integrated type, to be interconnected to each other. Generally, all electronic components are equipped with contact ends, commonly referred to as "pins", through which they can be electrically connected to said conductive tracks at locations which are predetermined by the circuit structure and by welding.

Many people have certainly had the opportunity to examine a PC motherboard or a small board of a mobile electronic device, such as a mobile phone, a walkman, a palmtop. On those occasions it was clear how the electronic board can house discrete or integrated electronic components interconnected to each other by means of contact pins with the board conductive tracks.

In several applications it is impossible to include in a single board all the electronic components provided for a particular device. Moreover, the unification or clustering order and coherence of some operative functions suggest the use of a plurality of boards, each board controlling a specific function. The good operation of the whole device obviously depends on the presence of all the different boards.

The typology of a personal computer will now be examined by way of example, wherein a motherboard for supporting and supplying the electronic microprocessor and a plurality of additional boards is provided, each board controlling a specific function or operative management. We can consider, for example, the personal computer video board, the modem board, the expansion board(s) of the volatile memory, etc.

All the additional or completing boards are thus generally connected to the motherboard through fast-fit couplings between connectors allowing the supply and the electric signals to pass through. More particularly, the motherboard is equipped with several female connectors (slots) for housing corresponding laminar electric contacts, provided on each additional board. Generally, once they are coupled to the motherboard, the additional boards extend perpendicularly to the motherboard, the whole assembly assuming thus a quite complex configuration.

In several cases the board interconnection does not pose space problems. In fact personal computers provide for a vast space inside the covering shell, also to favour the disposal of the heat produced by the electronic components. However, in other types of application, particularly in measuring instruments or notebooks, the need for reduced space occupancy considerably constrains board interconnection.

It is known from documents US 5,648,891 and us 6,122,161 a circuit board assembly comprising a plurality of subassemblies, having substantially the same size and coplanar to each other. Each subassemblies carries one or more conductive pin connectors for connection into a system back plane.

It is also known from the document GB 2243247 a printed circuit board comprising a motherboard and daughterboard which, under control of guides, slides in a cut-out recess in the motherboard, and is located in the plane of the motherboard.

None of these documents however discloses a circuit board suitable for a electronic measuring device, wherein the need for reduced space occupancy constrains board interconnection.

The technical problem underlying the present invention is to provide an electronic board structure, particularly for electronic devices having a reduced space occupancy which constrains board interconnection, said board having such structural and functional features such to be configured in its parts according to the different needs, optimising the dimensions thereof and reducing to a minimum the number of connectors required for the connection to other boards or to interfaces for communicating outside the device.

### Summary of the invention

The solutive idea on which the present invention stands is to structure the board with a first main functionally independent portion and at least a second portion which is structurally independent but functionally additional to the first portion; the second portion is coplanar to the first portion and has at least an edge section with joint profile to a corresponding first portion edge section.

Advantageously, the two portions are electrically interconnected by means of at least one electric component positioned between the two portions and having a first pin group connected to contact tracks or bumps on the first board portion and a second pin group connected to contact tracks or bumps on the board second portion.

Moreover, each board portion comprises its own connector and the adjacent connectors of the first and second portions are coupled to a single interconnection connector.

The features and advantages of the board according to the invention will be apparent from the following description of an embodiment thereof given by way of non-limiting example with reference to the accompanying drawings.

### Brief description of the drawings

- Figure 1 is a perspective and schematic view of an electronic board according to the present invention;
- Figure 2 is a perspective and schematic view of the board of figure 1 in the assembling step;
- Figure 3 is a further perspective and schematic view of the board of figure 1 in the assembling step;
- Figure 4 is a further perspective and schematic view of the board of figure 1 in the assembling step;
- Figure 5 is a schematic exploded view in the assembling step of an electronic device comprising the board according to the invention;
- Figure 6 is a further schematic view of the electronic device of figure 5.

### Detailed description

With reference to said drawings, an electronic board according to the present invention is generally and schematically indicated with 1.

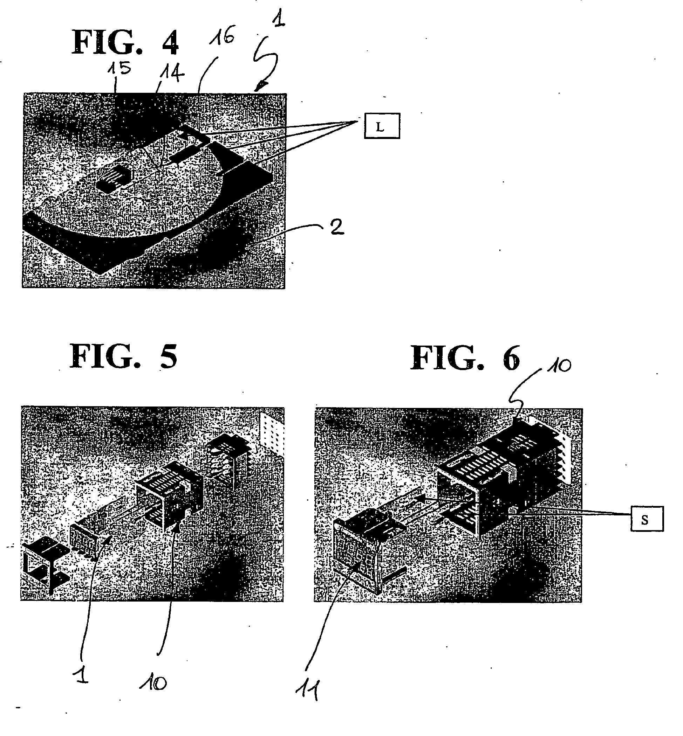

The board 1 is suitable to be housed in the protective shell 10 of an electronic device 11 having a reduced space occupancy which constrains board interconnection. More particularly, but not exclusively, the board 1 is suitable to be housed inside a measuring instrument schematically shown in figures 5 and 6.

The board 1 is flat and made of an electrically insulating material and comprises a plurality of conductive tracks realised on the board surface or, alternately, nested inside the board, according to the manufacturing method. In fact the conductive tracks can be realised as printed circuit or metalization lines by means of photolitographic engraving and superficial deposition techniques. Said conductive tracks are suitable for electric interconnections between discrete or integrated electronic components, mounted on the board 1.

Advantageously, according to the invention, the board 1 comprises a first main portion 2 which is structurally and functionally independent. This first portion 2 could be also referred to as base or mother portion.

The main portion 2 is equipped at one end with interconnection means 3 to the device 11 and, more particularly, with laminar contacts or simple metalization areas, which are to be removably coupled with hooking and electric interconnection countermeans, for example to the so-called female connector sliding contacts.

The board 1 also comprises a second secondary portion 5 in addition to the first portion 2. This second portion 5 is structurally and functionally independent, or optional, with respect to the first portion 2; but it is strictly associated to the first portion 2 and completes it. In a preferred embodiment the second portion 5 has a lower surface than the first portion 2, but the parts can be obviously inverted.

In greater detail, the second portion 5 is coplanar to the first portion 2 and has at least an edge section 6 with a profile joint to a corresponding edge section 7 of the first portion 2.

The two portions 2 and 5 are essentially adjacent and mating along a section of the peripheral edge thereof. The profile of the boundary section can be straight, curvilinear or irregular; the relevant matter is that both portions 2, 5 have at least a segment of said section with joint profile.

Moreover, the coupling joint profile can have a particular shape, for example a saw tooth projection 14 joint to a corresponding recess 15, ensuring the resistance to a traction and/or a longitudinal thrust which could occur during the board 1 insertion or extraction steps from the sliding contact connector. The coupling of the projection to the recess essentially prevents the board portions from freely transversally moving.

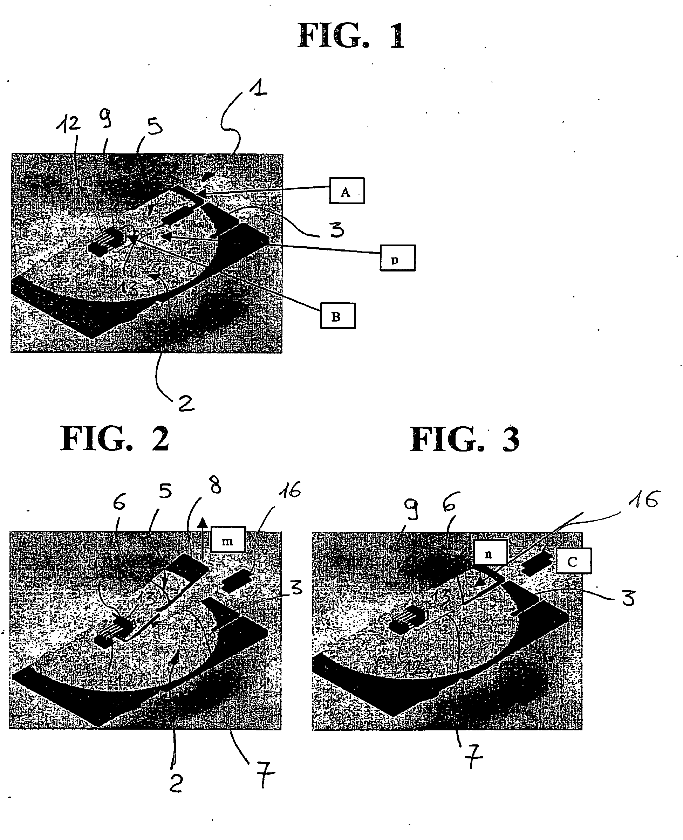

A spring 16 made of elastic material, for example a polycarbonate, is used as fitting to prevent any possible transversal movement between the secondary portion 5 and the base portion 2 of the board 1. The spring 16 is removably inserted between the edges 6 and 7 as shown in figure 3. For its elastic characteristics the spring 16 is kept in position and holds the edges 6, 7 of the portions 2 and 5.

The second secondary portion 5 is equipped at one end with interconnection means 8 to the device 11 and, particularly, with laminar contacts suitable for coupling in turn to female connector sliding contacts. Advantageously, the contacts 3 and 8 of the first 2 and second 5 portions are adjacent and coplanar when the two portions are reciprocally associated and coupled to the same single electric interconnection connector.

Moreover, the two portions 2 and 5 are electrically interconnected by at least one electronic component 9 positioned between the two portions 2, 5 and having a first pin group 12 connected to contact tracks or bumps on the first portion 2 of the board 1 and a second pin group 13 connected to contact tracks or bumps on the second portion 5 of the board 1.

The second additional portion 5 can be supplied through the connector 8 and exchange control signals with the motherboard through the interconnection electronic component 9.

In the embodiment here described by way of non limiting example the board 1 has generally a rectangular shape with the connectors 3 and 8 positioned in correspondence with a short side of the rectangular shape. The second portion 5 of the board 1 is of elongate rectangular shape and completes matingly the first portion 2 so that the latter assumes a rectangular shape. In other words, the second portion 5 seems to be a fragment or, in any case, a missing part of the first portion 2 and only the coupling of the two portions allows the so-formed entire board to assume the rectangular shape.

From the previous description it results that the present invention is particularly advantageous for those applications involving boards which can be divided in several functional blocks. In fact, if different typologies of functional blocks can be associated, it is possible to manufacture boards having different functions or boards with additional functions and options with respect to a base version.

The invention essentially allows the manufacture of small additional boards, i.e. secondary portions 5 of a base board 2, which are integrable into the base board they exchange control signals with and directly insertable in a single supporting connector from which they draw the electric supply.

It is evident from the above how the electronic board structure according to the invention solves the technical problem and achieves several advantages, the first one being that the board can be configured in its parts according to the different needs and allows the size of the electronic device which houses it to be optimised.

Moreover, the number of connectors needed for connection to other boards or interfaces for communication outside the electronic device is reduced to the minimum. This also allows a considerable reduction of overall manufacturing costs since the board assembly, considered as a single board, can be inserted in the same sliding contact connector.

A practical example of the invention is shown in figures 5 and 6 which illustrate the use of some two-component boards in the manufacture of a measuring instrument.

## Claims

1. An electronic board (1) suitable for being housed in a electronic measuring devices (11) and supporting discrete or integrated electronic components electrically interconnected by means of conductive tracks realised on or in the board (1), and comprising a first main functionally independent portion (2) and at least a second secondary portion (5), structurally independent but functionally additional to the first portion (2), said second portion (5) being coplanar to the first portion (5) with at least one edge section (6) having its profile joint to one corresponding edge section (7) of the first portion (2), wherein said first (2) and second (5) portions are shaped so as said second portion (5) completes matingly said first portion (2) seeming a missing part thereof and that said first (2) and second (5) portions comprise their own means (3, 8) for electrical interconnection to said electronic measuring device **characterised in that** the interconnection means (3, 8) of the first portion (2) and of the second portion (5) are positioned adjacent and on the same side of said electronic board so as to be coupled to a single support and interconnection connector of said electronic measuring device.

2. An electronic board according to claim 1, **characterised in that** said portions (2, 5) are electrically interconnected by at least one electronic component (9) positioned between them and having a first pin group (12) connected to contact tracks or bumps on the first portion (2) of the board (1) and a second pin group (13) connected to contact tracks or bumps on the second portion (5) of the board (1).

3. An electronic board according to claim 2, **characterised in that** the joint profile of the coupling section (6, 7) has a projection (14) and a corresponding recess (15) to ensure a traction resistance occurring during the board (1) insertion or extraction steps from said support connector.

4. An electronic board according to claim 3, **characterised in that** said projection (14) and said recess prevent the board portions (2, 5) from moving freely.

5. An electronic board according to claim 2, **characterised in that** said electronic component (9) is suitable for electric signal exchange between the secondary portion (5) and the main portion (2).

6. An electronic board according to claim 1, **characterised in that** it comprises a spring (16) made out of elastic material and removably inserted between said edge sections (6, 7) to prevent any possible transversal movement between the secondary portion (5) and the base portion (2) of the board (1).

7. An electronic board according to claim 1, **characterised in that** it has a rectangular shape, said second portion (5) being a part of said rectangular shape.

8. An electronic board according to claim 1, **characterised in that** said second portion (5) has a lower area than the first portion (2).

## Patentansprüche

1. Elektronische Platte (1), die sich zur Aufnahme in einer elektronischen Messvorrichtung (11) eignet und diskrete oder integrierte elektronische Bauteile trägt, die durch Leiterbahnen elektrisch miteinander verbunden sind, die auf oder in der Platte (1) ausgeführt sind, und einen ersten funktionell unabhängigen Hauptteil (2) sowie wenigstens einen sekundären Teil (5) umfasst, der strukturell unabhängig, funktionell jedoch ergänzend zu dem ersten Teil (2) ist, wobei der zweite Teil (5) koplanar zu dem ersten Teil (2) ist und das Profil wenigstens eines Randabschnitts (6) mit einem entsprechenden Randabschnitt (7) des ersten Teils (2) verbunden ist, der erste (2) und der zweite (5) Teil so geformt sind, dass der zweite Teil (5) den ersten Teil (2) eingreifend ergänzt und ein fehlender Teil desselben zu sein scheint, und der erste (2) sowie der zweite (5) Teil ihre eigenen Einrichtungen (3, 8) zur elektrischen Verbindung mit der elektronischen Messvorrichtung umfassen,
**dadurch gekennzeichnet,**
**dass** die Verbindungseinrichtung (3, 8) des ersten Teils (2) und des zweiten Teils (5) aneinandergrenzend und an der gleichen Seite der elektronischen Platte so angeordnet sind, dass sie mit einem einzelnen Trage-und-Verbindungs-Verbinder der elektronischen Messvorrichtung gekoppelt sind.

2. Elektronische Platte nach Anspruch 1, **dadurch gekennzeichnet, dass** die Teile (2, 5) elektrisch durch wenigstens ein elektronisches Bauteil (9) miteinander verbunden sind, das zwischen ihnen angeordnet ist und eine erste Stiftgruppe (12), die mit Kontaktbahnen oder Löthügeln an dem ersten Teil (2) der Platte (1) verbunden ist, sowie eine zweite Stiftgruppe (13) aufweist, die mit Kontaktbahnen oder Löthügeln an dem zweiten Teil (5) der Platte (1) verbunden ist.

3. Elektronische Platte nach Anspruch 2, **dadurch gekennzeichnet, dass** das verbundene Profil des Kopplungsteils (6, 7) einen Vorsprung (14) und eine entsprechende Vertiefung (15) aufweist, um einen Zugwiderstand während der Schritte des Einführens oder Herausziehens der Platte (1) in den bzw. aus dem Trageverbinder zu gewährleisten.

4. Elektronische Platte nach Anspruch 3, **dadurch gekennzeichnet, dass** der Vorsprung (14) und die Vertiefung verhindern, dass sich die Plattenteile (2, 5) frei bewegen.

5. Elektronische Platte nach Anspruch 2, **dadurch gekennzeichnet, dass** sich das elektronische Bauteil (9) zum Austausch elektrischer Signale zwischen dem sekundären Teil (5) und dem Hauptteil (2) eignet.

6. Elektronische Platte nach Anspruch 1, **dadurch gekennzeichnet, dass** sie eine Feder (16) umfasst, die aus elastischem Material besteht und herausnehmbar zwischen den Randabschnitten (6, 7) eingefügt ist, um etwaige mögliche Querbewegung zwischen dem sekundären Teil (5) und dem Basisteil (2) der Platte (1) zu verhindern.

7. Elektronische Platte nach Anspruch 1, **dadurch gekennzeichnet, dass** sie eine rechteckige Form hat, wobei der zweite Teil (5) ein Teil der rechteckigen Form ist.

8. Elektronische Platte nach Anspruch 1, **dadurch gekennzeichnet, dass** der zweite Teil (5) eine kleinere Fläche hat als der erste Teil (2).

## Revendications

1. Panneau électronique (1) adapté pour être logé dans un dispositif de mesure électronique (11) et pour supporter des composants électroniques discrets ou intégrés, électriquement interconnectés au moyen de pistes conductrices réalisées sur ou dans le panneau (1) et comprenant une première portion principale fonctionnellement indépendante (2) et au moins une seconde portion secondaire (5), structurellement indépendante mais fonctionnellement complémentaire de la première portion (2), ladite seconde portion (5) étant coplanaire à la première portion (5) avec au moins une section de bord (6) ayant son profil relié à une section de bord (7) correspondante (7) de la première portion (2), dans lequel ladite première portion (2) et ladite deuxième portion (5) ont une forme telle que ladite seconde portion (5) complète de manière conjuguée ladite première portion (2) en ayant l'air d'être une partie manquante de la première portion (2) et ladite première portion (2) et ladite deuxième portion (5) comprennent leur propre moyen (3, 8) pour une interconnexion électrique au dit dispositif de mesure électronique **caractérisé en ce que** les moyens d'interconnexion (3, 8) de la première portion (2) et de la seconde portion (5) sont positionnés à proximité et du même côté que ledit panneau électronique de manière à être couplé à un support unique et à un connecteur d'interconnexion dudit dispositif de mesure électronique.

2. Panneau électronique selon la revendication 1, **caractérisé en ce que** lesdites portions (2, 5) sont électriquement interconnectées par au moins un composant électronique (9) positionné entre elles et comportant un premier groupe de goupilles (12) connecté pour entrer en contact avec les pistes ou les bosses de la première portion (2) du panneau (1) et un second groupe de goupilles (13) connecté pour entrer en contact avec les pistes ou les bosses sur la seconde portion (5) du panneau (1).

3. Panneau électronique selon la revendication 2, **caractérisé en ce que** le profil de joint de la section d'accouplement (6, 7) comporte une saillie (14) et une encoche correspondante (15) pour garantir une résistance à la traction se produisant au cours des étapes d'insertion ou d'extraction du panneau par rapport au connecteur de support.

4. Panneau électronique selon la revendication 3, **caractérisé en ce que** ladite projection (14) et ladite encoche empêchent les portions de panneaux (2, 5) de bouger.

5. Panneau électronique selon la revendication 2, **caractérisé en ce que** ledit composant électronique (9) est adapté à un échange de signal électrique entre la portion secondaire (5) et la portion principale (2).

6. Panneau électronique selon la revendication 1, **caractérisé en ce qu'**il comprend un ressort (16) constitué de matériau élastique et pouvant être inséré de manière amovible entre lesdites sections de bord (6, 7) pour empêcher tout déplacement transversal éventuel entre la portion secondaire (5) et la portion de base (2) du panneau (1) .

7. Panneau électronique selon la revendication 1, **caractérisé en ce qu'**il a une forme rectangulaire, ladite seconde portion (5) étant une partie de ladite forme rectangulaire.

8. Panneau électronique selon la revendication 1, **caractérisé en ce que** ladite seconde portion (5) a une surface inférieure à celle de la première portion (2).
